# EUROPÄISCHE PATENTSCHRIFT

(11) **EP 0 456 892 B1**
(45) Veröffentlichungstag und Bekanntmachung des Hinweises auf die Patenterteilung: **20.10.1993**
(21) Anmeldenummer: 90122831.2
(22) Anmeldetag: 29.11.1990
(51) Int. Cl.: C23C 14/26, C23C 14/24

(54) **Reihenverdampfer für Vakuumbedampfungsanlagen**
Line evaporator for vacuum evaporation
Evaporateur en ligne pour la vaporisation sous vide

(30) Priorität: 14.05.1990 DE 4015385
(43) Veröffentlichungstag der Anmeldung: 21.11.1991
(73) Patentinhaber: LEYBOLD AKTIENGESELLSCHAFT, D-63450 Hanau (DE)
(72) Erfinder: Heinz, Jochen, W-6307 Linden (DE); Krug, Thomas, Dr., W-6450 Hanau (DE); Ruebsam, Klemens, W-6485 Jossgrund (DE); Kessler, Hans, W-6450 Hanau (DE)

(56) Entgegenhaltungen:
- DE-A- 1 237 401
- DE-A- 2 402 111
- US-A- 3 387 116

## Beschreibung

Die Erfindung betrifft einen Reihenverdampfer für Vakuumbedampfungsanlagen, insbesondere für Bandbedampfungsanlagen, bestehend aus mehreren, einzeln in der Leistung steuerbaren, durch Stromdurchgang beheizten, auf stützenförmig ausgebildeten elektrischen Zuleitungen befestigten Verdampfern, wobei die stützenförmigen Zuleitungen von einem sich über die gesamte Länge des Reihenverdampfers erstreckenden, elektrisch leitfähigen Tragkörper gehalten sind und die Zuleitungen der einen Polarität elektrisch leitend mit dem Tragkörper verbunden sind, während die Zuleitungen der anderen Polarität isoliert durch den Tragkörper hindurchgeführt und mit isoliert angeordneten Leitungsdrähten verbunden sind.

Bekannt ist ein Reihenverdampfer (US 3,387,116), bei dem das trogförmiger Verdampferschiffchen zwischen einer ersten ortsfesten, stützenförmigen Zuleitung und einem unter Federspannung stehenden, an einer zweiten ortsfesten Zuleitung gehalten und geführten Druckstück eingespannt ist.

Diese bekannte Vorrichtung hat den Nachteil, daß das Austauschen des Verdampferschiffchens zeitraubend ist, da für den Austausch die Federspannung mit Hilfe von Werkzeugen verringert werden muß und die Entnahme des Schiffchens unbequem ist, da dieses nur schwer zugänglich ist.

Der vorliegenden Erfindung liegt die Aufgabe zugrunde, einen Reihenverdampfer zu schaffen, bei dem die Nachteile der bekannten Vorrichtung nicht gegeben sind, und der vor allem eine Kühlung der stützenförmigen Zuleitung ermöglicht, der unempfindlich gegen Verschmutzen ist und bei dem alle flexiblen oder federnden Elemente außerhalb des Strahlenbereichs der Verdampferquelle liegen.

Diese Aufgabe wird erfindungsgemäß dadurch gelöst, daß die durch den Tragkörper mit Spiel hindurchgeführten stützenförmigen Zuleitungen von Federelementen beaufschlagt sind, die etwa parallel der Längserstreckungen der Verdampfer wirken und die Kopfteile der Zuleitungen an die diesen zugekehrten Stirnflächen der Verdampfer anpressen, wobei die Federelemente selbst gegenüber dem Tragkörper elektrisch isoliert gehalten und geführt oder aus isolierendem Werkstoff gebildet sind und die mit diesen Zuleitungen verbundenen Leitungsdrähte von einem Kühlmittel durchflossene Leiter sind oder als Kühlschläuche oder Kühlrohre ausgebildet sind, die zu den Leitungsdrähten parallel verlegt sind und in Kammern oder Kanälen einmünden, die in den Zuleitungen vorgesehen sind.

Weitere Ausführungsformen und Merkmale sind in den Patentansprüchen näher beschrieben und gekennzeichnet.

Die Erfindung läßt die verschiedensten Ausführungsmöglichkeiten zu; eine davon ist in der anhängenden Zeichnung näher dargestellt, die eine Vorrichtung zur Halterung eines Verdampfers einer Vakuumbedampfunfgsanlage in der Seitenansicht und teilweise im Schnitt zeigt.

Der Reihenverdampfer besteht im wesentlichen aus einem als T-Profilleiste ausgebildeten Tragkörper 6, dessen Oberseite mit einer Vielzahl von parallel zueinander angeordneten, L-förmigen Stützkörpern 25 verschraubt ist, mit denen jeweils stützenförmige Zuleitungen 3 verbunden sind, deren untere Enden ebenfalls bei 26 mit dem Tragkörper 6 fest verschraubt sind.

Die Zuleitungen 3 sind jeweils mit einem Kopfteil 17 verschraubt, deren Nase 16 jeweils an einem trogförmigen Verdampfer 5 anliegt, der sich jeweils in einer zum Tragkörper 6 parallelen Ebene erstreckt. Das der Zuleitung 3 abgekehrte Ende jedes Verdampfers 5 liegt jeweils an der Nase 15 des Kopfteils 9 einer stützenförmigen Zuleitung 4 an, die im Gegensatz zur dieser gegenüberliegenden Zuleitung 3 in einer horizontalen Ebene verschiebbar auf dem Tragkörper 6 gehalten ist.

Um diese Verschiebbarkeit in den Pfeilrichtungen A und B zu ermöglichen, ist die Zuleitung jeweils mit einem Kragenteil 13 versehen, über das sich die Zuleitung 4 auf einem ringförmigen Isolierstück 14 abstützt, wobei sich der untere Abschnitt der Zuleitung 4 durch eine Öffnung 22 mit Spiel a, b hindurch erstreckt.

Damit die Zuleitung 4 nicht nach oben zu aus der Öffnung 22 hinausgleiten kann, ist eine untere Führungsplatte 27 über eine Schraube 28 mit dem Kragenteil 13 verbunden, wobei Isolierstücke 29, 30 zwischen dem Kopf der Schraube 28 und dem Kragenteil 13 bzw. zwischen der Führungsplatte 27 und dem Tragkörper 6 angeordnet sind.

Da die Schrauben 28 außerdem durch eine Bohrung 31 im Kragenteil 13 hindurchgeführt ist, die weit größer bemessen ist als der Durchmesser des Schafts der Schraube 28, wird eine elektrisch leitende Verbindung zwischen der Zuleitung 4 und dem Tragkörper 6 ausgeschlossen.

An einer Seitenfläche 32 des Kragenteils 13 liegt ein Druckstück 33 an, das unter der Kraft der Druckfeder 8 steht, die in einer Isolierhülse 34 gelagert und abgestützt ist, die ihrerseits Teil eines Führungskörpers 23 ist, der mit einer Schraube 35 am Tragkörper 6 gehalten ist.

Da die Schraube 35 die Bohrung 36 mit Spiel durchgreift, kann der Führungskörper 23 in bestimmten Grenzen auf dem Tragkörper 6 verschoben werden. Der Führungskörper 23 stützt sich an einer ortsfest, jedoch drehbar gelagerten Nockenwelle bzw. an einem Nockenrad 24 ab, so daß die Kraft, mit der die Feder 8 auf die Zuleitung 4 in Pfeilrichtung A einwirkt, einstellbar ist.

Die Zuleitung 4 ist elektrisch leitend mit dem Leitungsdraht 7, der schlauchförmig ausgebildet ist, verbunden, wobei der Leitungsdraht 7 eine Schlauchleitung 11 umschließt, durch die Kühlmittel in den Kanal 12 gefördert werden kann. Dieses Kühlmittel kann dann, nachdem es die Kammer 12 durchströmt hat, durch eine Schlauch- oder flexible Rohrleitung 37 wieder abgepumpt werden.

Zwischen den Nasen 16 bzw. 15 der beiden stützenförmigen Zuleitungen 3, 4 und dem zwischen ihnen gehaltenen bzw. eingeklemmten Verdampfer 5 sind Graphitfolien 19, 20 eingelegt, die dafür Sorge tragen, daß ein möglichst verlustloser Stromübergang zwischen den Zuleitungen 3, 4 und dem Verdampfer 5 erfolgt.

Wird nun die Nockenwelle bzw. das Nockenrad 24 gegenüber der dargestellten Position verdreht, dann verringert sich die auf den Verdampfer 5 einwirkende Spannkraft der Feder 8, so daß die Zuleitung 4 geringfügig in Pfeilrichtung B ausweichen kann; der Verdampfer 5 läßt sich dann ohne weiteres gegen einen anderen Verdampfer von gleicher Länge austauschen.

Im übrigen ist am Kragenteil 13 der stützenförmigen Zuleitung 4 noch ein schirmförmiger Balg 21 vorgesehen, der sicherstellt, daß keine Verdampferreste oder sonstiger Schmutz in die Bohrungen 22 und 31 gerät und die freie Beweglichkeit der Zuleitung 4 behindert.

### Auflistung der Einzelteile

- 3: Zuleitung
- 4: Zuleitung
- 5: Verdampfer, Verdampferschiffchen
- 6: Tragkörper
- 7: Leitungsdraht, Hochstromzuführung
- 8: Federelement
- 9: Kopfteil
- 10: Stirnfläche
- 11: Kühlschlauch
- 12: Kanal
- 13: Kragenteil
- 14: Isolierstück
- 15: Nase
- 16: Nase
- 17: Kopfteil
- 18: Fläche
- 19: Graphitfolie
- 20: Graphitfolie
- 21: Balg
- 22: Öffnung
- 23: Führungskörper
- 24: Nockenrad
- 25: Stützkörper
- 26: Verschraubung
- 27: Führungsplatte
- 28: Schraube
- 29: Isolierstück
- 30: Isolierstück
- 31: Bohrung
- 32: Seitenfläche
- 33: Druckstück
- 34: Isolierhülse
- 35: Schraube
- 36: Bohrung
- 37: flexible Rohrleitung

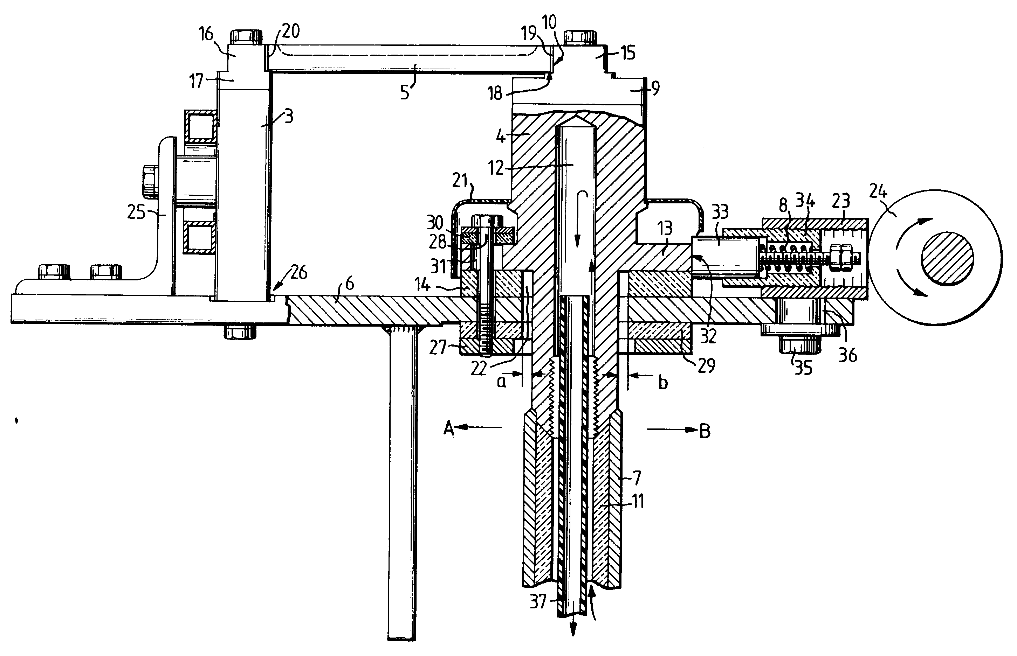

## Patentansprüche

1. Reihenverdampfer für Vakuumbedampfungsanlagen, insbesondere für Bandbedampfungsanlagen, bestehend aus mehreren, einzeln in der Leistung steuerbaren, durch Stromdurchgang beheizten, auf stützenförmig ausgebildeten elektrischen Zuleitungen (3, 4) befestigten Verdampfern (5), wobei die stützenförmigen Zuleitungen (3, 4) von einem sich über die gesamte Länge des Reihenverdampfers erstreckenden, elektrisch leitfähigen Tragkörper (6) gehalten sind und die Zuleitungen (3)der einen Polarität elektrisch leitend mit dem Tragkörper (6) verbunden sind, während die Zuleitungen (4) der anderen Polarität isoliert durch den Tragkörper (6) hindurchgeführt und mit isoliert angeordneten Leitungsdrähten (7) verbunden sind, ***dadurch gekennzeichnet,*** daß die durch den Tragkörper (6) mit Spiel (a, b) hindurchgeführten stützenförmigen Zuleitungen (4) von Federelementen (8) beaufschlagt sind, die etwa parallel der Längserstreckungen der Verdampfer (5) wirken und die Kopfteile (9) der Zuleitungen (4) an die diesen zugekehrten Stirnflächen (10) der Verdampfer (5) anpressen, wobei die Federelemente (8) selbst gegenüber dem Tragkörper (6) elektrisch isoliert gehalten und geführt oder aus isolierendem Werkstoff gebildet sind und die mit diesen Zuleitungen (4) verbundenen Leitungsdrähte (7) von einem Kühlmittel durchflossene Leiter sind oder als Kühlschläuche (11) oder Kühlrohre ausgebildet sind, die zu den Leitungsdrähten (7) parallel verlegt sind und in Kammern oder Kanälen (12) einmünden, die in den Zuleitungen (4) vorgesehen sind.

2. Reihenverdampfer nach Anspruch 1, ***dadurch gekennzeichnet,*** daß die stützenförmigen Zuleitungen (4) mit flanschartigen Kragenteilen (13) versehen sind und sich über diese Kragenteile (13) und über zwischengelegte Isolierstücke (14) am Tragkörper (6) abstützen.

3. Reihenverdampfer nach den Ansprüche 1 und 2, ***dadurch gekennzeichnet,*** daß die Federelemente aus am Tragkörper kippbar gelagerten, von Druckfedern beaufschlagten Hebeln gebildet sind, die sich über Druckstücke aus isolierendem Werkstoff an den stützenförmigen Zuleitungen abstützen.

4. Reihenverdampfer nach einem oder mehreren der vorhergehenden Ansprüche, ***dadurch gekennzeichnet,*** daß das Kopfteil (9) jeder stützenförmigen Zuleitung (4) an einem Ende mit einer Ausnehmung oder Nase (15) versehen ist, die jeweils sowohl eine sich horizontal erstreckende Fläche (18) bildet, auf der ein Ende des jeweils zugeordneten Verdampfers (5) aufliegt, als auch eine sich etwa vertikal erstreckende Fläche, an der sich die jeweilige Stirnfläche (10) des Verdampfers abstützt, wobei zwischen Verdampferstirnfläche und Abstützfläche der Zuleitung (4) eine Graphitfolie (19) eingelegt ist.

5. Reihenverdampfer nach einem oder mehreren der vorhergehenden Ansprüche, ***dadurch gekennzeichnet,*** daß die stützenförmigen, mit den das Kühlwasser führenden Hochstromdurchführungen (7) verbundenen Zuleitungen (4) die flanschartigen Kragenteile (13) übergreifende Balgen (21) aufweisen, wobei die unteren offene Ränder der Balgen (21) im Bereich der Oberseite des Tragkörpers (6) enden und so ein Verschmutzen der Öffnungen (22) im Tragkörper (6) verhindern.

6. Reihenverdampfer nach einem oder mehreren der vorhergehenden Ansprüche, ***dadurch gekennzeichnet,*** daß das auf die bewegliche stützenförmige Zuleitung (4) einwirkende Federelement (8) in einem Führungskörper (23) gehalten und geführt ist, der seinerseits auf der Oberseite des Tragkörpers (6) angeordnet ist und über ein drehbares, auf dem Tragkörper gelagertes Nockenrad (24) in seinem Abstand (f) zur stützenförmigen Zuleitung (4) einstellbar ist.

7. Reihenverdampfer nach einem oder mehreren der vorhergehenden Ansprüche, ***dadurch gekennzeichnet,*** daß die mit der Hochstromzuführung (7) verbundene stützenförmige Zuleitung (4) auf einem Schlitten gehalten ist, der mit dem Tragkörper (6) in Wirkverbindung steht und eine Verschiebung der Zuleitung (4) gegenüber der Öffnung (22) in Längsrichtung der Verdampfer (5) ermöglicht, eine Verschiebung in vertikaler Richtung jedoch ausschließt.

## Claims

1. Series vaporiser for vacuum sputtering devices, in particular for belt sputtering devices, consisting of a plurality of vaporisers (5), which are individually controllable in terms of output, are heated by the passage of current through them, and are fixed on support-like electrical supply lines (3, 4), wherein the support-like supply lines (3, 4) are held by an electrically conductive carrier body (6) extending over the whole length of the series vaporiser and the supply lines (3) of the one polarity are electrically conductively connected to the carrier body (6), whilst the supply lines (4) of the other polarity pass through the carrier body (6) in a insulated manner and are connected to conducting wires (7) mounted in an insulated manner, characterised in that the support-like supply lines (4) passing through the carrier body (6) with clearance (a, b) are acted on by spring elements (8), which operate approximately parallel to the longitudinal extensions of the vaporisers (5) and which press the top parts (9) of the supply lines (4) against the end faces (10) of the vaporisers (5) facing them, in which case the spring elements (8) themselves are held and guided electrically insulated relative to the carrier body (6) or are formed of insulating material, and the conducting wires (7) connected to these supply lines (4) are conductors having a coolant flowing through them or are formed as cooling hoses (11) or cooling pipes, which are laid parallel to the conducting wires (7) and open out into chambers or channels (12) provided in the supply lines (4).

2. Series vaporiser according to claim 1, characterised in that the support-like supply lines (4) are provided with flange-like collar parts (13) and are supported on the carrier body (6) via these collar parts (13) and via interposed insulating members (14).

3. Series vaporiser according to claims 1 and 2, characterised in that the spring elements consist of levers acted on by pressure springs and mounted tiltably on the carrier body, said levers bearing on the support-like supply lines via pressure members composed of insulating material.

4. Series vaporiser according to one or more of the preceding claims, characterised in that the top part (9) of each support-like supply line (4) is provided at one end with a recess or lug (15), which in each case forms both a horizontally extending face (18) on which one end of the respectively associated vaporiser (5) rests, as well as an approximately vertically extending face on which the respective end face (10) of the vaporiser is supported, in which case a sheet of graphite (19) is inserted between the vaporiser end face and the support face of the supply line (4).

5. Series vaporiser according to one or more of the preceding claims, characterised in that the support-like supply lines (4) connected to the high-current ducts (7) carrying the cooling water have bellows devices (21) engaging over the flange-like collar parts (13), and the lower open edges of the bellow devices (21) end in the region of the upper face of the carrier body (6) and thus prevent contamination of the apertures (22) in the carrier body (6).

6. Series vaporiser according to one or more of the preceding claims, characterised in that the spring element (8) acting on the moving, support-like supply line (4) is held and guided in a guide body (23), which is in turn disposed on the upper face of the carrier body (6) so that its distance (f) from the support-like supply line (4) is adjustable via a rotary cam wheel (24) mounted on the carrier body.

7. Series vaporiser according to one or more of the preceding claims, characterised in that the support-like supply line (4) connected to the high-current supply line (7) is mounted on a carriage, which is operatively connected to the carrier body (6) and permits displacement of the supply line (4) relative to the aperture (22) in the longitudinal direction of the vaporiser (5) but prevents displacement in the vertical direction.

## Revendications

1. Evaporateur en série pour installations d'évaporation sous vide, notamment pour installations d'évaporation sur bandes, composées de pluieurs évaporateurs (5) à réglage individuel de la puissance, chauffés par passage de courant, fixés sur des conducteurs électriques (3, 4) d'amenée du courant en de support, les conducteurs d'amenée (3, 4) en forme de support étant tenus par un élément porteur (6) conducteur de l'électricité, qui s'étend sur toute la longueur de l'évaporateur en série, et les conducteurs d'amenée (3) d'une polarité étant reliés électriquement à l'élément porteur (6) tandis que les conducteurs d'amenée (4) de l'autre polarité sont passés à travers l'élément porteur (6) en traversée isolante et sont reliés à des fils conducteurs (7) montés avec isolation, caractérisé en ce que les conducteurs d'amenée (4) en forme de support qui sont passés avec jeu (a, b) à travers l'élément porteur (6) sont chargés par des éléments élastiques (8) qui agissent à peu près parallèlement à la direction longitudinale des évaporateurs (5) et les parties de tête (9) des conducteurs d'amenée (4) sont pressées contre les surfaces frontales (10) des évaporateurs (5) dirigées vers ces conducteurs, les éléments élastiques (8) étant eux-mêmes maintenus et guidés en restant isolés électriquement de l'élément porteur (6), ou étant formés d'une matière isolante, et les fils conducteurs (7) connectés à ces conducteurs d'amenée (4) étant des conducteurs parcourus par un fluide de refroidissement, ou étant constitués par des tuyaux de refroidissement (11) ou des tubes de refroidissement qui sont disposés parallèlement aux fils conducteurs (7) et débouchent dans des chambres ou canaux (12) qui sont prévus dans les conducteurs d'amenée (4).

2. Evaporateur en série selon la revendication 1, caractérisé en ce que les conducteurs d'amenée (4) en forme de support sont munis de parties collerettes (13) en forme de bride et prennent appui sur l'élément porteur (6) par l'intermédiaire de ces parties collerettes (13) et de pièces isolantes (14) interposées.

3. Evaporateur en série selon les revendications 1 et 2, caractérisé en ce que les éléments élastiques sont constitués par des leviers montés oscillants sur l'élément porteur et chargés par des ressorts de compression, et qui prennent appui sur les conducteurs d'amenée en forme de support par l'intermédiaire de pièces de pression en matière isolante.

4. Evaporateur en série selon une ou plusieurs des revendications précédentes, caractérisé en ce que la pièce de tête (9) de chaque conducteur d'amenée (4) en forme de support est munie à une extrémité d'un évidement ou nez (15) qui forme, d'une part, une surface (18) s'étendant dans la direction horizontale, sur laquelle repose une extrémité de l'évaporateur (5) correspondant et, d'autre part, une surface s'étendant à peu près verticalement, contre laquelle prend appui la surface frontale (10) correspondante de l'évaporateur, une feuille de graphite (19) étant interposée entre la surface frontale de l'évaporateur et la surface d'appui du conducteur d'amenée (4).

5. Evaporateur en série selon une ou plusieurs des revendications précédentes, caractérisé en ce que les conducteurs d'amenée (4) en forme de support, qui sont reliés aux traversées de haute tension (7) qui conduisent l'eau de refroidissement, présentent des soufflets (21) qui recouvrent les parties collerettes (13) en forme de bride, les bords inférieurs ouverts des soufflets (21) se terminant dans la région de la face supérieure de l'élément porteur (6) et évitant ainsi l'encrassage des ouvertures (22) de l'élément porteur (6).

6. Evaporateur en série selon une ou plusieurs des revendications précédentes, caractérisé en ce que l'élément élastique (8) qui agit sur le conducteur d'amenée mobile (4) en forme de support est tenu et guidé dans un corps de guidage (23) qui, de son côté, est disposé sur la face supérieure de l'élément porteur (6) et peut être réglé, en distance d'écartement (f) par rapport au conducteur d'amenée (4) en forme de support, au moyen d'une came rotative (24) tourillonnée sur l'élément porteur.

7. Evaporateur en série selon une ou plusieurs des revendications précédentes, caractérisé en ce que le conducteur d'amenée (4) en forme de support relié à l'amenée de haute tension (7) est monté sur un chariot qui est lié à l'élément porteur (6) et permet de faire coulisser le conducteur d'amenée (4) par rapport à l'ouverture (22) dans la direction longitudinale de l'évaporateur (5) mais exclut tout coulissement dans la direction verticale.
